# EUROPÄISCHE PATENTSCHRIFT

(11) **EP 4 695 901 B1**
(45) Veröffentlichungstag und Bekanntmachung des Hinweises auf die Patenterteilung: **02.09.2026**
(21) Anmeldenummer: 25734368.1
(22) Anmeldetag: 18.06.2025
(51) Int. Cl.: H02S 20/10, H10F 19/80

(54) **VERTIKALE SOLARPANELVORRICHTUNG UND SOLARPANELSYSTEM MIT DERSELBEN**
VERTICAL SOLAR PANEL DEVICE AND SOLAR PANEL SYSTEM HAVING THE SAME
DISPOSITIF DE PANNEAU SOLAIRE VERTICAL ET SYSTÈME DE PANNEAU SOLAIRE LE COMPRENANT

(30) Priorität: 18.06.2024 AT 962024
(43) Veröffentlichungstag der Anmeldung: 18.02.2026
(73) Patentinhaber: Sunbooster GmbH, 8045 Graz (AT)
(72) Erfinder: PONSOLD, stefan, 8045 Graz (AT)
(74) Vertreter: Mathys & Squire
(86) Internationale Anmeldenummer: PCT/EP2025/067196
(87) Internationale Veröffentlichungsnummer: WO 2025/262180

(56) Entgegenhaltungen:
- EP-A1- 2 450 967
- FR-A1- 3 134 653
- NL-B1- 2 025 487
- US-A1- 2016 254 404
- US-B2- 8 283 560

## Beschreibung

Die vorliegende Erfindung betrifft eine vertikale Solarpanelvorrichtung zur vertikal orientierten photovoltaischen Stromerzeugung, und ein vertikales Solarpanelsystem zur vertikal orientierten photovoltaischen Stromerzeugung, das die vertikale Solarpanelvorrichtung mehrfach umfasst.

### Technisches Gebiet der Erfindung

Die vertikale Solarpanelvorrichtung findet Anwendung in der regenerativen Stromerzeugung durch Photovoltaik, insbesondere im Bereich der Einfriedung von Grundstücken.

### Hintergrund der Erfindung

Es sind verschiedenen Anwendungen der vertikalen Photovoltaik bekannt, die unter anderem auch in kleinerer Dimensionierung und Leistung von Haushalten und Endverbrauchern genutzt werden. Hierzu zählen beispielsweise solche Anlagen, die im Allgemein als Balkonkraftwerk bekannt sind.

Ferner werden in letzter Zeit unter dem Begriff der vertikalen Photovoltaik weitere Systemprodukte auf den Markt gebracht, die beispielsweise in einer begrenzten Leistungsklasse eingeordnet sind und eine erleichterte Montage in Eigenleistung durch den Endverbraucher ermöglichen sollen. Hiermit wird einerseits das Spektrum an geeigneten Flächen zur Befestigung von Photovoltaikanlagen durch vertikale Installationen erweitert, die leichter zugänglich als Dachflächen eines Gebäudes sind. Zudem werden durch die erleichterte Montage die Investitionen für die Errichtung und Inbetriebnahme gesenkt. Somit werden kleinere Photovoltaikanlagen für eine größere Anzahl an Haushalten leistbar und rentabel, wodurch eine wachsende Anzahl an Endverbrauchern zu einer Energiewende in der regionalen Energieversorgung mittels regenerativer Energieerzeugung beiträgt.

In dem genannten Anwendungsbereich der vertikalen Photovoltaik werden zunehmend Zaunflächen als bereits vorhandene und in der Regel leicht zugängliche Flächen als alternative oder zusätzliche Installationsräume genutzt. Teilweise werden Solarmodule mit ausreichender mechanischer Festigkeit als Ganzes anstelle von Zaunabgrenzungselementen zwischen Zaunpfosten eingesetzt. Anderenfalls werden derartige oder herkömmliche Solarmodule an bzw. vor einer Seite eines bestehenden Zaunes angebracht. Bei letzterer Variante besteht das Problem, dass ein zulässige Belastung der Zaunkonstruktion von dem Gewicht mehrerer benachbarter Solarmodule schnell überschritten wird.

EP 2 450 967 A1 offenbart ein flexibles PV-Modul, bei dem die Solarzellen vollständig durch ein flexibles Schutzmember verkapselt sind. Im Randbereich weist das Schutzmember Durchgangslöcher zur Befestigung auf. Zur Vermeidung von Rissen an diesen Löchern werden zusätzliche Verstärkungselemente 202, 204 vorgesehen, die auf Vorder- und Rückseite des Schutzmembers angeordnet sind und den Randbereich übergreifen. Diese Elemente sind separate, mechanisch festere Bauteile, die z.B. durch Schrauben, Nieten oder Klebstoff befestigt werden.

In den drei deutschen Gebrauchsmustern DE 20 2017 103 757 U1 DE 20 2023 002 026 U1 und DE 20 2023 102 994 U1 ist, zumindest im Rahmen von Beschreibungen alternativer Ausführungsformen, in Ansätzen eine neuen Gattung von flexiblen Solarmodulen beschrieben worden. Derartige flexible Solarmodule sind dazu vorgesehen, zwischen Gitterstäben eines Zaunes in horizontaler Richtung eingefädelt zu werden, ähnlich wie die bekannte Installation von Sichtschutzelementen, die in Form von gewebten Bändern in einer Gittermatte eines Zaunes eingefädelt angebracht werden.

Die FR 3 134 653 A1 schlägt ein photovoltaisches Modul vor, das eine geringe flächenbezogene Masse, was unter anderem durch einen leichten Modulrahmen aus Verbundwerkstoff realisiert wird.

Die US 8 283 560 B2 offenbart eine photovoltaische Vorrichtung, die eine Verringerung von Reflektionsverlusten an einer aktiven Schicht durch eine spezielle Oberflächengestaltung erzielt.

Die NL 2 025 487 B1 offenbart Solarpanele, die leicht sind und keine verwindungssteife Unterkonstruktion aufweisen, so dass diese in einen Zaun eingeflochten werden können.

Schließlich offenbart die US 20016/254404 A1 ein leichtes und flexibles photovoltaisches Panel vor, das leicht, dünn, möglichst flexibel und dennoch mechanisch ausreichend robust gegen Hagelniederschlag ist. Hierfür wird einen Verbundwerkstoff mit Glasfasern in bestimmten Schichten eingesetzt. Die genannten Dokumente geben Anhaltspunkte zu grundlegenden Eigenschaften eines geeigneten Solarmoduls bzw. Solarpanels für diese spezifische Anwendung, wobei insbesondere in einer derzeitigen frühen Phase dieser neuen Gattung von Solarpanels Bedarf an technische Verbesserungen besteht.

### Kurzfassung der Erfindung

Es ist eine Aufgabe der Erfindung eine Technik zu schaffen, welche die Effizienz eines Solarpanels der eingangs genannten Gattung verbessert. Alternativ besteht eine weitere Aufgabe der Erfindung darin, eine Technik zu schaffen, welche die Haltbarkeit oder die Wartung einer entsprechenden Photovoltaikanlage mit Solarpanels der eingangs genannten Gattung verbessert.

Die voranstehende Aufgabe wird gelöst durch eine vertikale Solarpanelvorrichtung mit den Merkmalen des Anspruchs 1. Weitere Merkmale und Details der Erfindung ergeben sich aus den Unteransprüchen, der Beschreibung und den Zeichnungen.

Die Erfindung sieht eine flexible und bifaciale Solarpanelvorrichtung vor, die sich insbesondere vorteilhafter Weise für eine vertikale Installation an einem Zaun eignet, bei dem die Solarpanelvorrichtung in ihrer flexiblen Erstreckung von beiden gegenüberliegenden Zaunseiten aus zwischen vertikalen Stäben oder Zaunlatten hindurch gefädelt wird.

Die erfindungsgemäße Solarpanelvorrichtung umfasst eine erste flexible Schutzschicht aus einem transparenten polymerbasierten Material, die zu einer nach außenweisenden Seite der ersten Trägerschicht angeordnet ist, und eine zweite flexible Schutzschicht aus einem transparenten polymerbasierten Material, die zu einer nach außenweisenden Seite der zweiten Trägerschicht angeordnet ist.

Als ein Vorteil der Erfindung, wird durch die zusätzlich zu beiden Seiten angeordneten flexiblen Schutzschichten die Solarpanelvorrichtung zusätzlich vor Witterungseinflüssen und insbesondere mechanischen Einwirkungen geschützt. Dadurch werden die Haltbarkeit verbessert und ein Wartungsaufwand der Solarzellenvorrichtung oder eines entsprechenden Photovoltaiksystems verringert.

Erfindungsgemäß wird an wenigstens einem Endabschnitt der Solarpanelvorrichtung ein Querschnitt eines Schichtaufbaus, umfassend die Solarzellen die erste Trägerschicht und die zweite Trägerschicht zu einer Außenseite der Solarpanelvorrichtung hin von der ersten Schutzschicht und/oder von der zweiten Schutzschicht überdeckt.

Als ein großer Vorteil der Erfindung, bieten erstmals die Schutzschichten einen verbesserten Schutz gegen Witterungseinflüsse, sodass diese vorzugsweise auch einen offenen Querschnitt des Schichtaufbaus der Solarpanelvorrichtung überdecken und vor eindringender Feuchtigkeit schützen.Das erfindungsgemäße flexible, bifaciale Solarpanel verbessert den Ertrag der photovoltaischen Stromerzeugung, da auch reflektiertes Licht aus verschiedenen Richtungen auf einer primären und einer sekundären photovoltaischen Seite aufgenommen und in elektrische Energie umgewandelt wird. Ein besonderes Potential der Ertragssteigerung ermöglicht das erfindungsgemäße flexible bifaciale Solarpanel in dem vorliegenden spezifischen Anwendungsfall der vertikalen Photovoltaik, bei dem es durch das Tragwerk in Form eines Zaunes weitgehend unverdeckt beidseitig exponiert ist.

Mit anderen Worten ermöglicht die Kombination der Merkmale der mechanischen Flexibilität und der der Bifacialität der vertikalen Solarpanelvorrichtung eine besondere Steigerung der Effizienz und des Ertrags, da die Eigenschaften einer Befestigungsmöglichkeit mit in etwa gleichwertiger abschattungsfreier Exposition an beiden gegenüberliegenden Seiten eines Zaunes und die Eigenschaft der photovoltaischen Stromerzeugung zu beiden Seiten des Zaunes durch ein und dieselbe Solarpanelvorrichtung zugleich in vorteilhafterweise verfügbar und nutzbar gestellt werden.

Vorteilhafterweise kann somit je nach Ausrichtung eines Zaunes zu verschiedenen Tageszeiten zunächst eine Sonneneinstrahlung aus Richtung Osten einfallend und später eine Sonneneinstrahlung aus Richtung Westen einfallend durch dieselbe Installation mit nur ein und derselben installierten Solarpanelvorrichtung bezogen auf eine Flächeneinheit des Zaunes genutzt werden. Dadurch wird die Effizienz der Solarpanelvorrichtung erheblich verbessert und der Ertrag einer entsprechenden Anlage mit mehreren Solarpanelvorrichtungen an demselben Zaun deutlich gesteigert.

In diesem Zusammenhang bestehen weitere Vorteile der Erfindung. Zum einen bietet die flexible Eigenschaft der erfindungsgemäßen Solarpanelvorrichtung eine leichte Befestigung durch Hindurchfädeln durch vertikale Elemente eines Zaunes, ohne Hilfe eines Fachmanns und in einfacher Ausführung auch ohne Bedarf an Befestigungsmitteln und Werkzeug.

Zum anderen ermöglicht der flexible und somit relativ dünne und leichte Aufbau der erfindungsgemäßen Solarpanelvorrichtung, dass eine gesamte Zaunfläche mit derartigen Solarpanels bespannt werden kann, ohne eine zulässige Traglast des Zaunes zu überschreiten. Mit anderen Worten wird eine zulässige Belastung bei weitem unterschritten, was wiederum der Haltbarkeit der Verankerung der Zaunpfosten und Befestigung der Gittermatten an den Zaunpfosten zugutekommt.

Durch den bifacialen Aufbau der erfindungsgemäßen Solarpanelvorrichtung ist es nicht erforderlich, zwei gegenüberliegende Solarmodule bzw. Solarpanels an beiden Seiten des Zaunes anzubringen, wodurch Systemkosten und Gewicht in Bezug auf die Zaunfläche eingespart werden.

Im Vergleich zu einer fiktiven Konstruktion, bei der ein herkömmliches starres bifaciales Solarmodul zu einer Seite eines Zaunes installiert wird, ermöglicht die erfindungsgemäße flexible, bifaciale Solarpanelvorrichtung die Vorteile, dass es leichter ist und bei vorgesehener Anbringung keine einseitige Belastung bzw. kein dauerhaftes einseitiges Moment auf die Zaunkonstruktion aufbringt. Insbesondere jedoch ermöglicht das erfindungsgemäße flexible, bifaciale Solarpanel in dem genannten Vergleich eine Befestigung mit geringerer Abschattung, da bei der genannten einseitigen Installation eines herkömmlichen starren bifacialen Solarmoduls bzw. Solarpanels zu einer Seite des Zaunes, sämtliche Elemente des Zaunes wie Stäbe oder Zaunlatten zu einer Abschattung und Minderung der Effizienz auf einer dem Zaun zugewandten Seite des herkömmlichen Solarmoduls bzw. Solarpanels beitragen.

Gemäß einem vorteilhaften Aspekt der Erfindung können die Solarzellen im Wesentlichen gleiche Abmessungen aufweisen, wobei in einer horizontal orientierten Längsrichtung, in der die Solarzellen in einer Reihe zueinander beabstandet angeordnet sind, ein Anordnungsintervall, innerhalb dem sich eine Anordnung von benachbarten Solarzellen wiederholt, 40 mm bis 60 mm, vorzugsweise 50 mm beträgt. Diese Maßgabe entspricht einer Abstimmung auf einen Abstand von vertikalen Stäben eines genormten Musters an einem weitverbreiteten sogenannten Doppelstabmattenzaun. Durch die Abstimmung der Maße zwischen der Anordnung der Solarzellen und dem Muster des Zaunes wird eine einseitige Verdeckung von Flächen der Solarzellen durch vertikale Stäbe verhindert oder auf ein Minimum reduziert, wodurch die Effizienz des Solarpanels verbessert wird.

Gemäß einem vorteilhaften Aspekt der Erfindung kann eine Abmessung in einer vertikal orientierten Querrichtung, die quer zu der Längsrichtung verläuft, von 180 mm bis 200 mm, vorzugsweise 190 mm. Diese Maßgabe entspricht einer Abstimmung auf einen Abstand von horizontalen Doppelstäben des genormten Musters an dem weitverbreiteten Doppelstabmattenzaun. Die Abstimmung der Maße zwischen der Anordnung der Solarzellen und dem Muster des Zaunes ermöglicht eine Maximierung der Flächen der Solarzellen auf die zur Verfügung stehenden Räume zwischen den horizontalen Doppelstäben, wodurch die Effizienz des Solarpanels verbessert wird.

Gemäß einem vorteilhaften Aspekt der Erfindung kann die Solarpanelvorrichtung versetzt auslaufende Endabschnitte in der horizontal orientierten Längsrichtung umfassen, wobei die versetzt auslaufenden Endabschnitte in Bezug auf die vertikal orientierte Querrichtung in wenigstens zwei Abschnitte unterteilt sind, und die wenigstens zwei Abschnitte sich jeweils mit unterschiedlicher Länge in der Längsrichtung nach außen erstrecken. Die unterschiedlich auslaufenden Enden führen an einem Übergang zwischen horizontal benachbarten Solarpanelvorrichtungen zu einer versetzten Überlappung, die eine mechanische Verzahnung oder gegenseitige Befestigung, ähnlich wie ein Puzzle, ermöglicht. Dadurch wird eine gegenseitige Fixierung geschaffen, die dazu verhilft, unter Windlast das Auftreten eines Flatterns der freien horizontalen Enden jeder Solarpanelvorrichtung zu vermeiden oder weitgehend zu unterdrücken. Dadurch werden eine dynamische Belastung auf die Enden der flexiblen Solarpanelvorrichtungen an einem Zaun verringert, womit die Haltbarkeit verbessert und ein Wartungsaufwand verringert werden.

Gemäß einem vorteilhaften Aspekt der Erfindung kann das transparente polymerbasierte Material der ersten Trägerschicht und/oder der zweiten Trägerschicht Ethylenvinylacetat (EVA) umfassen. Ethylenvinylacetat zeichnet sich in der Anwendung als Trägerschicht durch die Eigenschaften eine hohen Transparenz, der guten UV-Beständigkeit und die mechanische Flexibilität aus, sodass ein Ablösung einzelner Schichten in dem Aufbau der Solarpanelvorrichtung verhindert und die strukturelle Integrität verbessert wird. Dadurch werden die Haltbarkeit verbessert und ein Wartungsaufwand der Solarzellenvorrichtung oder eines entsprechenden Photovoltaiksystems verringert.

Gemäß einem vorteilhaften Aspekt der Erfindung kann das transparente polymerbasierte Material der ersten Schutzschicht und/oder der zweiten Schutzschicht Polyethylenterephthalat (PET) oder Ethylen-Tetrafluorethylen (ETFE) oder vorzugsweise Polyvinylfluorid (PVF) umfassen. Die drei Materialen zeichnen sich in der Anwendung als Schutzschicht durch die Eigenschaften einer hohen Witterungsbeständigkeit, einer hohen Transparenz, einer guten UV-Beständigkeit, die mechanische Flexibilität und durch eine hohe Schlagzähigkeit aus. Dadurch werden die Haltbarkeit verbessert und ein Wartungsaufwand der Solarzellenvorrichtung oder eines entsprechenden Photovoltaiksystems verringert.

Gemäß einem vorteilhaften Aspekt der Erfindung kann die erste Schutzschicht und/oder die zweite Schutzschicht eine nach außenweisende Oberfläche umfassen, in der ein Muster von konkav graduell ausgeformten Kavitäten mit einem Durchmesser von 1000 bis 5000 Mikrometern, vorzugsweise 3000 bis 3500 Mikrometern und einer Tiefe von 100 bis 500 Mikrometern, vorzugsweise 250 bis 350 Mikrometern ausgebildet ist. Durch diese Oberflächenstruktur können Ablagerung von Schmutz und Kalk, die aus Wassertropfen wie Regenniederschlag oder kondensierende Luftfeuchtigkeit auf der Oberfläche anhaften, verringert werden. Zudem wirkt die Oberflächenstruktur wie eine Vielzahl von plankonkaven Zerstreuungslinsen, die Lichtstrahlen aus unterschiedlichen Richtungen optisch streuen und mit einer homogeneren Verteilung von Auftreffwinkel gleichmäßiger auf die Solarzellen richten. Dadurch werden sowohl die Effizienz verbessert als auch ein Wartungsaufwand zur Reinigung der Solarzellenvorrichtung oder eines entsprechenden Photovoltaiksystems verringert.

Gemäß einem vorteilhaften Aspekt der Erfindung kann die Solarpanelvorrichtung wenigstens einen elektrischen Verbinder aufweisen, der eine elektrische Verbindung zwischen einer elektrischen Verschaltung der Solarzellen und Anschlüssen für einen elektrischen Zusammenschluss der Solarpanelvorrichtung mit weiteren Solarpanelvorrichtungen bereitstellt; wobei der elektrische Verbinder einen mittels eines Schaltelements schaltbaren, elektrischen Bypass umfasst, der eine von der Verschaltung der Solarzellen elektrisch getrennte Überbrückung zwischen den Anschlüssen bereitstellt. Der schaltbare Bypass ermöglicht im Falle einer Abschattung der Solarpanelvorrichtung eine Überbrückung dieser Solarpanelvorrichtung in einem Zusammenschluss mehrerer Solarpanelvorrichtungen, wodurch eine Gesamteffizienz eines Solarpanelsystems mit mehreren Solarpanelvorrichtungen erhöht wird.

Gemäß einem vorteilhaften Aspekt er Erfindung kann eine vertikale Solarpanelvorrichtung derart ausgebildet sein, dass die Solarzellen entlang der Reihe, welche sich in Montagesituation in einem Zaunsystem mit vertikal verlaufenden Zaunstäben quer zur den Zaunstäben erstreckt, eine Breite von 45 mm bis 55 mm aufweisen. Auf diese Weise korrelieren die Abmessungen der einzelnen Solarzellen in der Breite vorzugsweise mit entsprechenden Abständen der Zaunstäbe, welche in einem entsprechenden Zaunsystem, ebenfalls einen Abstand von circa 45 mm bis 55 mm aufweisen. Durch diese Korrelation ergibt sich der Vorteil, dass jede Solarzelle, bei frontaler Sonneneinstrahlung, immer nur von maximal einem Zaunstab verschattet wird. Es gibt dadurch weder eine doppelte Verschattung noch vollständige Freiflächen zwischen den Stäben. Dies wirkt sich positiv auf die Gleichmäßigkeit der beidseitigen Nutzung und der Symmetrie hinsichtlich des Ertrages aus.

Gemäß einem vorteilhaften Aspekt der Erfindung kann ein Solarpanelsystem zur vertikal orientierten photovoltaischen Stromerzeugung wenigstens eine der zuvor genannten vertikalen Solarpanelvorrichtungen umfassen, ebenso wie ein Zaunelement mit vertikal ausgerichteten, parallel beabstandeten Stäben und horizontal ausgerichteten, parallel beabstandeten Stäben; wobei die wenigstens eine vertikale Solarpanelvorrichtung innerhalb eines Abstands der horizontal ausgerichteten Stäbe, zwischen mehreren der vertikal ausgerichteten Stäbe alternierend hindurch gefädelt angeordnet ist. Somit wird eine besonders einfache und bezüglich einer beidseitigen Lichteinstrahlung sehr effektive Installation der erfindungsgemäßen vertikalen Solarpanelvorrichtung bereitgestellt.

Gemäß einem vorteilhaften Aspekt der Erfindung kann an dem Solarpanelsystem ein Muster der alternierend hindurch gefädelten Anordnung der wenigstens einen vertikalen Solarpanelvorrichtung eine ungleichmäßige Aufteilung in Bezug auf zwei gegenüberliegende Seiten des Zaunelementes aufweisen; wobei die ungleichmäßige Aufteilung vorzugsweise in Bezug auf die Längsrichtung eine überwiegende Erstreckung der vertikalen Solarpanelvorrichtung umfasst, an der die primäre photovoltaische Oberfläche der Solarzellen zu den vertikal ausgerichteten Stäben des Zaunelementes abgewandt ist. Somit wird eine mögliche Verdeckung der Fläche der Solarzellen durch vertikale Stäbe des Zaunes insbesondere an der Primärseite der bifacialen Solarzellen minimiert und eine Effizienz des Solarpanelsystem, bestehend aus den Solarpanelvorrichtungen und dem Zaun, verbessert.

### Kurzbeschreibung der Zeichnung

Weitere Vorteile, Merkmale und Einzelheiten der Erfindung ergeben sich aus der nachfolgenden Beschreibung, in der unter Bezugnahme auf die Zeichnungen, Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Fig. 1: einen Querschnitt durch einen Schichtaufbau der flexiblen bifacialen Solarpanelvorrichtung gemäß einer Ausführungsform der Erfindung,
- Fig. 2: eine Draufsicht auf eine Seitenfläche von Solarpanelvorrichtungen gemäß unterschiedlichen Ausführungsformen der Erfindung;
- Fig. 3: eine Draufsicht auf eine Seitenfläche von Solarpanelvorrichtungen, die in einen Zaun eingefädelt sind, gemäß einer Ausführungsformen der Erfindung;
- Fig. 4A: einen Querschnitt durch einen Schichtaufbau an einem Endabschnitt der Solarpanelvorrichtung gemäß einem Ausführungsbeispiel; und
- Fig. 4B: einen Querschnitt durch einen Schichtaufbau an einem Endabschnitt der Solarpanelvorrichtung gemäß einem alternativen Ausführungsbeispiel.

### Ausführliche Beschreibung der Ausführungsformen

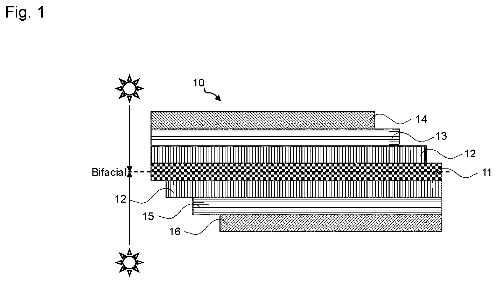

In Fig. 1 ist ein schematischer Querschnitt durch einen Schichtaufbau der flexiblen Solarpanelvorrichtung 10 in einem Bereich, in dem eine Solarzelle 11 angeordnet ist. Die Solarzelle 11 ist in der Mitte des Schichtaufbaus angeordnet, und sie ist bifacial, sodass sie zu beiden Seiten Sonnenlicht aufnehmen und in eine Spannung zwischen zwei Elektroden (nicht explizit dargestellt) erzeugen kann. Die Solarzelle 11 ist in Form einer mechanisch flexiblen Folie mit bekannten fotoaktiven Materialen ausgebildet. Dabei weist die bifaciale Solarzelle 11 in der Regel, jedoch nicht zwangsweise, eine primäre Seite und eine sekundäre Seite auf, wobei die Leistungsfähigkeit oder Effizienz der primären Seite geringfügig höher als diejenige der sekundären Seite ist.

Die primäre Seite und die sekundäre Seite der Solarzelle 11 sind mittels eines transparenten Haftmittels 12, das heißt mittels eines geeigneten Klebstoffes für Polymere auf einer ersten Trägerschicht 13 und einer zweiten Trägerschicht 15 aufgebracht. Die erste Trägerschicht 13 und die zweite Trägerschicht 15 sind transparent, mechanisch flexibel und bestehen vorzugsweise aus Ethylenvinylacetat (EVA). EVA besitzt für diese Anwendung bevorzugte Eigenschaften, da es UV-beständig ist, eine Ablösung einzelner Schichten verhindert und somit die strukturelle Integrität des Schichtaufbaus steigert.

Vorzugsweise wird für die Trägerschichten 13, 15 eine EVA-Schicht mit folgenden Eigenschaften verwendet: FIRST F406P / F806P (PID-resistent, VA28 ± 2 %, Gel > 75 %); Dicke 0,45 mm. Der hohe PID-Schutz erfüllt eine Eigenschaft von weniger als 5 % Leistungsverlust nach Testbedingungen von 96 h bei 85 °C, was im Zusammenhang mit der genannten Anwendung als besondere Materialeigenschaft zur Langzeitbeständigkeit anzusehen ist. Darüber verfügt das Material über eine optische Transmission von mehr als 91 % im Lichtwellenlängenbereich von 380 - 1100 nm, einer UV-Blockung von mehr als 80 % unter Lichtwellenlänge von 380 nm, was im Zusammenhang mit der genannten Anwendung für einen hervorragenden Kompromiss aus Schutz und Wirkungsgrad führt. Ferner ermöglicht die hohe Gel-Rate von mehr als 75 % im Herstellungsprozess eine kurze Laminierzeit von etwa 18 - 20 Minuten ohne Klebversagen, wodurch Zeit und Kosten in der Herstellung eingespart werden.

Auf die erste Trägerschicht 13 und die zweite Trägerschicht 15 sind eine erste Schutzschicht 14 und eine zweite Schutzschicht 16 auflaminiert. Auch die erste Schutzschicht 14 und die zweite Schutzschicht 16 sind transparent, mechanisch flexibel und bestehen vorzugsweise aus Polyethylenterephthalat (PET), Ethylen-Tetrafluorethylen (ETFE) oder Polyvinylfluorid (PVF). PET, ETFE und PVF sind witterungsbeständig, UV-beständig und weisen eine hohe Schlagzähigkeit auf, sodass diese einen guten Schutz für die innenliegenden Solarzellen 11 vor äußeren Einwirkungen bieten.

Vorzugsweise wird für die Schutzschichten 14, 16 eine PVF-Schicht mit folgenden Angaben verwendet: DuPont PVF, Dicke 0,40 mm; maximaler Biegewinkel 270 ° (≈ U-Förmig). PVF weist eine noch höhere UV- und Hydrolysebeständigkeit als PET oder ETFE auf und synergiert mit Mikrostrukturen anderer Schichten was zu einer verbesserten Integrität des laminierten Schichtaufbaus führt. In verschiedenen Ausführungsformen kann als Schutzschicht ein fluoriertes Polymer, insbesondere PVF, mit einer Dicke von 0,30 - 0,50 mm eingesetzt werden.

Somit ergeben sich in einer Reihenfolge eines symmetrischen Schichtaufbaus von oben nach unten folgende bevorzugte Maße: erste Schutzschicht 14 aus PVF mit 0,40 mm, erste Trägerschicht 13 aus EVA mit 0,45 mm, Solarzelle 11 mit 0,20 mm, zweite Trägerschicht 15 aus EVA mit 0,45 mm und zweite Schutzschicht 16 aus PVF mit 0,40 mm. In dieser Ausführungsform weist der Schichtaufbau eine Gesamtstärke von etwa 1,9 mm auf, wenn die Trägerschichten 13, 15 aus EVA jeweils 0,40 - 0,50 mm betragen, und die Schutzschichten 14, 16 aus PVF 0,35 - 0,45 mm betragen. Zuzüglich dem transparenten Haftmittel 12 gelangt ein Produkt der Solarpanelvorrichtung 10 mit den Spezifikationen und Dimensionen in der genannten Ausführungsform auf eine Gesamtstärke von etwa 2 mm.

Eine äußere Oberfläche der ersten Schutzschicht 14 und der zweiten Schutzschicht 16 sind mit einer Oberflächenstruktur (nicht weiter dargestellt) mit einer Vielzahl von konkaven, graduell ausgeformten Kavitäten versehen, ähnlich der Struktur und Form der Oberfläche eines Hammerschlaglacks. Die Kavitäten haben beispielsweise eine Abmessung von etwa 3300 Mikrometer bzw. 3,3 Millimeter und eine maximale Tiefe an einem Mittleren Punkt der konkaven Kavität von etwa 300 Mikrometer bzw. bzw. 0,3 Millimeter. Die Kavitäten wirken sich sowohl positiv auf ein Verhalten zur Herabsetzung von Schutzablagerungen von Kalk, Pollen und anderen Partikeln aus, die durch Nässe und Feuchtigkeit auf die Oberfläche gelangen, als auch auf eine gleichmäßige Streuung des aus unterschiedlichen Richtungen reflektierten und einfallenden Lichtes auf die darunterliegende Solarzellen 11 im Sinne einer plankonkaven Zerstreuungslinse in Bezug auf jede Kavität.

Zudem können optional in den zwei Schutzschichten 14, 16 Zugfasern aus Glasfaser oder Kohlefaser, also Kevlar einlaminiert bzw. integriert sein. Die Fasern haben eine Länge von mehr als 5 mm und weisen eine Zugfestigkeit von mehr als 1 GPa auf. Eine derartige, eingebettete Faserverstärkung in den zwei Schutzschichten 14, 16 nimmt verbessert Zugkräfte auf, die insbesondere während der Montage bei einem Straffziehen der zwischen den Stäben des Zaunes hindurchgefädelten Solarpanelvorrichtung 10 auftreten können.

Darüber hinaus können in einem weiteren Ausführungsbeispiel in regelmäßigen Abständen in der Längsrichtung L Sollbruchlinien vorgesehen sein, an denen ein erleichtertes Ablängen der Solarpanelvorrichtungen 10 ermöglicht wird. Die Sollbruchlinien können vorzugsweise als vorgestanzte Trennnuten nach jeweils 4 Solarzellen, oder einer geringeren Zellenanzahl ausgebildet sein. Für dieses Ausführungsbeispiel ist auch eine Produktkonfektionierung vorgesehen, bei der die Solarpanelvorrichtung 10 als Meterware auf eine Trommel gewickelt ist, und am Ort der Montage oder einer Station des Vertriebsweges für einen Kunden, auf erleichterte Weise auf ein individuelles Maß angepasst wird.

Zudem können auf der Oberfläche der Solarpanelvorrichtung 10 vorzugsweise integral ausgebildete, elastische Verrast-Laschen, sogenannte TPU-Klick-Laschen zur verbesserten Befestigung und erleichterten Montage bereitgestellt sein.

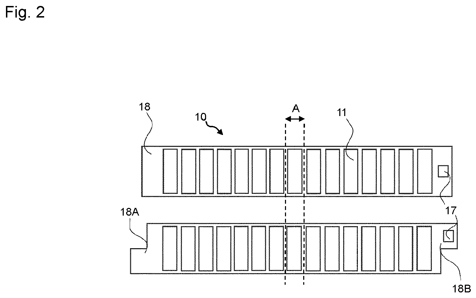

Fig. 2 zeigt eine schematische Draufsicht auf zwei Ausführungsformen der Solarpanelvorrichtung 10, die sich bezüglich einer Form von Endabschnitten 18, 18A, 18B unterscheiden. In beiden Abbildung ist die Solarpanelvorrichtung 10 als ein flexibler flacher Streifen ausgebildet, der in der oberen Abbildung eine rechteckige Form mit Endabschnitten 18 aufweist. In der unteren Abbildung sind komplementär ausgebildete Endabschnitte 18A und 18B vorgesehen, die sich, in Querrichtung Q unterteilt, in unterschiedlichem Maße in Längsrichtung L erstrecken und wie ein Puzzle ineinander passen. Somit kann eine bessere gegenseitige Fixierung von freien Enden von benachbarten Solarpanelvorrichtungen 10 erzielt werden, die dazu verhilft, eine Flatterbewegung von freien Enden bei Wind zu vermeiden.

Die Solarpanelvorrichtung 10 umfasst eine in Längsrichtung L erstreckende Reihe von Solarzellen 11. Die bifacialen Solarzellen 11 sind vorzugsweise von einem Zelltyp M6 166 mm mit 9 Busbars und einer Abmessung von 166 × 41,5 mm. Dabei kann die Solarpanelvorrichtung 10 bei einer Erstreckung in Längsrichtung L von 2,5 m eine Anzahl von 56 Zellen in einem vertikalen Zellenabstand von 1,2 mm umfassen, oder bei einer Erstreckung in Längsrichtung L von 2 m eine Anzahl von 44 Zellen mit einem vertikalen Zellenabstand von 1,5 mm umfassen. So wird eine geringstmögliche Abschattung durch Stäbe des Zaunes erzielt. Die Solarpanelvorrichtung 10 umfasst im Sinne einer Konfektionierung eines Solarmoduls eine bevorzugte Anzahl von 44 - 60 in Reihe verschalteten Teilzellen. Eine Teilzellenbreite beträgt vorzugsweise 41 - 43 mm, womit sich ein Intervall pro Solarzelle 11 und jeweiligem Abstand von vorzugsweise 50 mm mit einer Toleranz von +/- 0,5 mm ergibt.

Bei einer Ausführungsform mit einer Länge von 2,5 m ergibt sich ein Gewicht von etwa 1,1 kg mit einer Toleranz, je Variation von Material und Verkabelung, von +/- 0,4 kg. Eine flächenbezogene Masse der Solarpanelvorrichtung 10 liegt unter 0,45 kg m⁻¹, wodurch sich eine geringe Belastung für Zaunpfosten ergibt, die unter 50 % eines zulässigen Grenzwertes gemäß DIN EN 1991-1-4 liegt.

Die Solarzellen sind gemeinsam elektrisch verschaltet. An wenigstens einem der Endabschnitte 18, 18A, 18B ist ein elektrischer Verbinder 17 angeordnet, der z.B. zwei Anschlüsse für einen Zusammenschluss mit einem darüber und einem darunter angeordneten, benachbarten Solarpanelvorrichtung 10 ermöglicht. Der elektrische Verbinder ist als eine sogenannte Junction Box ausgestaltet, die auf der äußeren Oberfläche von der ersten Schutzschicht 14 oder von der zweiten Schutzschicht 16 aufgebracht ist, und Anschlüsse wie z.B. MC4 Stecker oder ein ähnliches gängiges Format umfasst. Der elektrische Verbinder 17 stellt eine elektrische Verbindung zwischen der Verschaltung der innenliegenden Solarzellen 11 und den Anschlüssen her. Optional umfasst der elektrische Verbinder 17 auf einen schaltbaren Bypass, der die Anschlüsse zu benachbarten Solarpanelvorrichtungen 10 direkt verbindet, und die Verschaltung der Solarzellen 11 von den Anschlüssen trennt, d.h. die betreffende Solarpanelvorrichtung 10 in einem Zusammenschluss mehrerer Solarpanelvorrichtungen 10 überbrückt. Hierdurch können solche Solarpanelvorrichtungen 10, die eine Teilabschattung oder vollständige Abschattung erfahren und somit die Effizienz eines gesamten Solarpanelsystems beeinträchtigen würden, überbrückt werden. Der schaltbare Bypass kann in Übereinstimmung mit Ausgangssignalen einer an sich bekannten Optimierervorrichtung wie einem Maximum Power Point Tracker (MPPT) geschaltet werden.

Vorzugsweise ist die Solarpanelvorrichtung 10 in einem Bypasskonzept verschaltet, wobei vorzugsweise 4 bis 8 seriell verschaltete Teilzellen durch eine Bypass-Diode überbrückt werden. Dadurch kann das Risiko von Hot-Spots und Ertragsverlusten aufgrund von Situationen mit ungleicher Flächenverteilung der Einstrahlung und Erzeugungsleistung verringert werden.

In Bezug auf eine Gestaltung der elektrischen Leiter im Inneren der Solarpanelvorrichtung 10 können diese sowohl durch herkömmliche Lötbänder, aber auch teilweise oder vollständig durch Bahnen aus elektrisch leitfähigen Klebstoffen realisiert werden, wodurch ein zulässiger Biegeradius der flexiblen Solarpanelvorrichtung 10 erhöht und ein Risiko zur Bildung von Mikrorissen in der Leiterstruktur verringert wird. In einem Ausführungsbeispiel sind eine komplette Leiterstruktur oder zumindest elektrische Verbindungen zur seriellen Verschaltung der benachbarten Solarzellen 11 aus einem leitfähigen Epoxid-Klebsysteme realisiert.

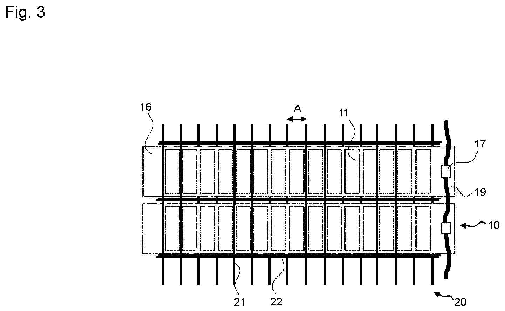

Fig. 3 zeigt schematisch ein Solarpanelsystem, bei dem beispielgebend zwei Solarpanelvorrichtungen 10 an einem Zaunelement 20 installiert sind. Dabei ist das Zaunelement 20 in Form eines sogenannten Doppelstabmattenzaunes mit einem genormten Muster bereitgestellt. Dieses weist in Querrichtung Q verlaufende vertikale Stäbe 21 in einem Abstand von 5 cm sowie in Längsrichtung L verlaufende horizontale Stäbe 22 bzw. Doppelstäbe in einem Abstand von 20 cm auf.

Die Anordnung der Solarzellen 11 in den Solarpanelvorrichtungen 10 beträgt 1,2 bis 1,5 mm, womit eine räumliche Abstimmung der Anordnung auf das standardisierte Muster eines Doppelstabmattenzaunes gegeben ist, und eine Abschattung der Solarzellen 11 durch die Stäbe 21, 22 eines Zaunelementes 20 minimiert wird.

Wie zuvor erwähnt, weist die Solarpanelvorrichtungen 10 mit dem obengenannten bevorzugten Schichtaufbau, der zwei Trägerschichten 13, 15 aus EVA und zwei Schutzschichten 14, 16 aus PVF umfasst, eine besondere Biegsamkeit von mehr als 270 ° auf, ohne einen Leistungsverlust.

Die Solarpanelvorrichtungen 10 sind durch die vertikalen Stäbe 21 des Zaunelementes 20 in einer beliebigen, vorzugsweise gleichmäßigen Reihenfolge zwischen beiden gegenüberliegenden Seiten des Zaunelementes 20 hindurch gefädelt. Dabei kann die Reihenfolge vorzugsweise so gewählt werden, dass die primäre Seite bzw. eine Ausrichtung zu einer ertragreicheren Richtung der Sonneneinstrahlung so gewählt werden, dass die primäre Seite von einer geringeren Anzahl von vertikalen Stäben 21 verdeckt wird als an der sekundären Seite. In dem dargestellten Ausführungsbeispiel ist die Seite der Draufsicht die primäre Seite der bifacialen Solarzellen 11.

Zudem sind in der dargestellten Ausführungsform die Solarzellen 11 in einem Anordnungsintervall A von 5 cm in der Solarpanelvorrichtung 10 der Reihe nach angeordnet, wodurch die Abmessung und Anordnung der Solarzellen auf den genormten Abstand der vertikalen Stäbe 21 von 5 cm abgestimmt ist. Alternativ können sich die Solarzellen 11 über ein Mehrfaches des Anordnungsintervalls, also über 10 cm, 15 cm oder 20 cm usw. in der Längsrichtung erstrecken.

Die beiden dargestellten Solarpanelvorrichtungen 10, die übereinander an dem Zaunelement 20 angeordnet sind, sind durch Verbindungkabel 19 elektrisch zusammengeschlossen. Die Verbindungskabel 19 sind durch Steckverbindungen wie die zuvor genannten MC4 Stecker mit den Anschlüssen der elektrischen Verbindern 17 verbunden.

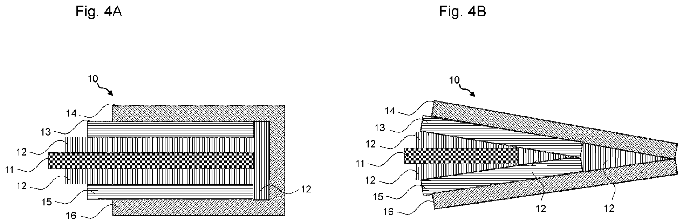

Die Figuren 4A und 4B zeigen zwei alternative Ausführungsbeispiele einer Gestaltung des Schichtaufbaus an einem Endabschnitt der Solarpanelvorrichtung 10. Die erste Schutzschicht 14 und die zweite Schutzschicht 16 erbringen im Vergleich zu der ersten Trägerschicht 13 und der zweiten Trägerschicht 15 einen verbesserten Witterungsschutz. Dies gilt insbesondere, wenn die erste Schutzschicht 14 und die zweite Schutzschicht 16 aus Ethylen-Tetrafluorethylen (ETFE) oder vorzugsweise aus Polyvinylfluorid (PVF) bestehen, und die erste Trägerschicht 13 und die zweite Trägerschicht 15 aus Ethylenvinylacetat (EVA) hergestellt sind. Die erste Schutzschicht 14 und die zweite Schutzschicht 16 sind derart angeordnet, dass sie auch an freien Enden der Solarpanelvorrichtung 10 alle übrigen weiter innen angeordneten Elemente, d.h. die Solarzellen 11 sowie äußere Enden der ersten Trägerschicht 13 und der zweite Trägerschicht 15 nach außen überdecken. Somit besteht vorzugsweise an allen Endkanten der Solarpanelvorrichtung 10 kein offener Querschnitt des Schichtaufbaus, durch den Feuchtigkeit oder sonstige äußere Einflüsse eindringen, und eine Laminierung des Schichtaufbaus beeinträchtigen können. Dabei können Freiräume zwischen den Enden der einzelnen Schichten durch das Haftmittel 12 aufgefüllt und somit abgedichtet sein.

Fig. 4A zeigt einen planaren Verlauf aller Schichten, wobei die erste Schutzschicht 14 und die zweite Schutzschicht 16 am Ende der Solarpanelvorrichtung 10 jeweils zu einer Hälfte um eine Dickenrichtung des Schichtaufbaus herumgeführt und abdichtend zusammengeführt sind. Gleiches gilt für eine verjüngend zulaufende Schichtanordnung in Fig. 4B, in der sich die erste Schutzschicht 14 und die zweite Schutzschicht 16 am Ende der Solarpanelvorrichtung 10 an einer Mittelachse des Schichtaufbaus zusammengeführt sind und eine Außenseite bedecken. Ebenso können weitere Mischformen als alternative Ausführungsbeispiele vorgesehen sein, bei denen eine Dicke des Schichtaufbaus beispielsweise stufenweise abnimmt, wobei die erste Schutzschicht 14 und die zweite Schutzschicht 16 nicht wie in Fig. 4A stirnseitig, sondern innenseitig in einen abdichtenden Kontakt gelangen. Ebenso können asymmetrische Ausführungsbeispiele vorgesehen sein, bei denen sich die erste Schutzschicht 14 und die zweite Schutzschicht 16 nicht im Bereich der Mittelachse des Schichtaufbaus treffen, sondern eine der beiden Schutzschichten 14, 16 an einem freien Ende zu einem größeren Teil oder vollständig um den offenen Querschnitt des Schichtaufbaus geführt ist.

Als ein weiterer optionaler Aspekt eines Ausführungsbeispiels kann in einem Randabschnitt der Solarpanelvorrichtung 10 ein mechanischer Spannungssensor integriert sein, der eine Dehnung der Solarpanelvorrichtung 10 überwacht. Dabei ist vorgesehen, dass der mechanische Spannungssensor ein Signal ausgibt, das einer Datenverarbeitung zu einer Benachrichtigung eines Nutzers zugeführt wird, vorzugsweise über eine Softwareschnittstelle an einem Endgerät, das zur Darstellung von Leistungsparametern der Solarpanelvorrichtung 10 verwendet wird. Als ein Schwellenwert für diese Funktionalität ist eine erfasste Dehnung von mehr als 0,3 % vorgesehen.

Die voranstehenden Erläuterungen der Ausführungsformen beschreiben die vorliegende Erfindung ausschließlich im Rahmen von Beispielen. Selbstverständlich können einzelne Merkmale der Ausführungsformen, sofern technisch sinvoll und soweit vom Gegenstand der Ansprüche umfasst, frei miteinander kombiniert werden, ohne den Rahmen der vorliegenden Erfindung zu verlassen.

### Bezugszeichenliste

- 10: Solarpanelvorrichtung
- 11: Solarzelle
- 12: Haftmittel
- 13: erste Trägerschicht
- 14: erste Schutzschicht
- 15: zweite Trägerschicht
- 16: zweite Schutzschicht
- 17: elektrische Verbinder
- 18: Endabschnitt
- 18A: versetzt auslaufender Endabschnitt
- 18B: versetzt auslaufender Endabschnitt (komplementär)
- 19: Verbindungskabel
- 20: Zaunelement
- 21: vertikale Stäbe
- 22: horizontale Stäbe (Doppelstäbe)

- A: Anordnungsintervall
- L: Längsrichtung
- Q: Querrichtung

## Patentansprüche

1. Vertikale Solarpanelvorrichtung (10) zur vertikal orientierten photovoltaischen Stromerzeugung, umfassend:
eine Mehrzahl von flexiblen Solarzellen (11), die in einer Reihe zueinander beabstandet angeordnet und elektrisch miteinander verbunden sind;
eine flexible erste Trägerschicht (13) aus einem transparenten polymerbasierten Material, wobei die Solarzellen (11) an einer primären photovoltaischen Oberfläche mittels eines transparenten Haftmittels (12) auf der ersten Trägerschicht (13) fixiert sind; wobei
die flexiblen Solarzellen (11) bifacial ausgebildet sind, mit einer sekundären photovoltaischen Oberfläche, die der primären photovoltaischen Oberfläche gegenüberliegt;
eine flexible zweite Trägerschicht (15) aus einem transparenten polymerbasierten Material, wobei die flexiblen Solarzellen (11) an der sekundären photovoltaischen Oberfläche mittels des transparenten Haftmittels (12) auf der zweiten Trägerschicht (15) fixiert sind;
eine erste flexible Schutzschicht (14) aus einem transparenten polymerbasierten Material, die zu einer nach außen weisenden Seite der ersten Trägerschicht (13) angeordnet ist, und eine zweite flexible Schutzschicht (16) aus einem transparenten polymerbasierten Material, die zu einer nach außen weisenden Seite der zweiten Trägerschicht (15) angeordnet ist; wobei auf die erste Trägerschicht (13) und die zweite Trägerschicht (15) die erste Schutzschicht (14) und die zweite Schutzschicht (16) auflaminiert sind,
**dadurch gekennzeichnet, dass**
an wenigstens einem Endabschnitt der Solarpanelvorrichtung (10) ein Querschnitt eines Schichtaufbaus, umfassend die Solarzellen (11), die erste Trägerschicht (13) und die zweite Trägerschicht (15), zu einer Außenseite der Solarpanelvorrichtung (10) hin von der ersten Schutzschicht (14) und/oder von der zweiten Schutzschicht (16) überdeckt ist.

2. Vertikale Solarpanelvorrichtung (10) nach Anspruch 1, wobei die Solarzellen (11) im Wesentlichen gleiche Abmessungen aufweisen, und wobei in einer horizontal orientierten Längsrichtung (L), in der die Solarzellen (11) in einer Reihe zueinander beabstandet angeordnet sind, ein Anordnungsintervall (A), innerhalb dem sich eine Anordnung von benachbarten Solarzellen (11) wiederholt, 40 mm bis 60 mm, vorzugsweise 50 mm beträgt.

3. Vertikale Solarpanelvorrichtung (10) nach Anspruch 1 oder 2, aufweisend eine Abmessung in einer vertikal orientierten Querrichtung (Q), die quer zu der Längsrichtung (L) verläuft, von 180 mm bis 200 mm, vorzugsweise 190 mm.

4. Vertikale Solarpanelvorrichtung (10) nach einem der vorhergehenden Ansprüche, mit versetzt auslaufenden Endabschnitten (18A, 18B) in der horizontal orientierten Längsrichtung (L), wobei die versetzt auslaufenden Endabschnitte (18A, 18B) in Bezug auf die vertikal orientierte Querrichtung (Q) in wenigstens zwei Abschnitte unterteilt sind, und die wenigstens zwei Abschnitte sich jeweils mit unterschiedlicher Länge in der Längsrichtung (L) nach außen erstrecken.

5. Vertikale Solarpanelvorrichtung (10) nach einem der vorhergehenden Ansprüche, wobei das transparente polymerbasierte Material der ersten Trägerschicht (13) und/oder der zweiten Trägerschicht (15) Ethylenvinylacetat (EVA) umfasst.

6. Vertikale Solarpanelvorrichtung (10) nach einem der vorhergehenden Ansprüche, wobei das transparente polymerbasierte Material der ersten Schutzschicht (14) und/oder der zweiten Schutzschicht (16) Polyethylenterephthalat (PET), Ethylen-Tetrafluorethylen (ETFE) oder vorzugsweise Polyvinylfluorid (PVF) umfasst.

7. Vertikale Solarpanelvorrichtung (10) nach einem der vorhergehenden Ansprüche, wobei die erste Schutzschicht (14) und/oder die zweite Schutzschicht (16) eine nach außen weisende Oberfläche umfasst, in der ein Muster von konkav graduell ausgeformten Kavitäten mit einem Durchmesser von1000 bis 5000 Mikrometern, vorzugsweise 3000 bis 3500 Mikrometern und einer Tiefe von 100 bis 500 Mikrometern, vorzugsweise 250 bis 350 Mikrometern ausgebildet ist.

8. Vertikale Solarpanelvorrichtung (10) nach einem der vorhergehenden Ansprüche, aufweisend wenigstens einen elektrischen Verbinder (17), der eine elektrische Verbindung zwischen einer elektrischen Verschaltung der Solarzellen (11) und elektrischen Anschlüssen für einen elektrischen Zusammenschluss der Solarpanelvorrichtung (10) mit weiteren Solarpanelvorrichtungen (10) bereitstellt; wobei
der elektrische Verbinder (17) einen mittels eines Schaltelements schaltbaren, elektrischen Bypass umfasst, der eine von der Verschaltung der Solarzellen (11) getrennte Überbrückung zwischen den elektrischen Anschlüssen bereitstellt.

9. Vertikale Solarpanelvorrichtung (10) nach einem der vorhergehenden Ansprüche, wobei die Solarzellen (11) entlang der Reihe, welche sich in Montagesituation in einem Zaunsystem mit vertikal verlaufenden Zaunstäben quer zur den Zaunstäben erstreckt, eine Breite von 45 mm bis 55 mm aufweisen.

10. Vertikales Solarpanelsystem zur vertikal orientierten photovoltaischen Stromerzeugung, umfassend:
wenigstens eine von der vertikalen Solarpanelvorrichtung (10) nach einem der Ansprüche 1 bis 9;
ein Zaunelement (20) mit vertikal orientierten, parallel beabstandeten Stäben (21) und horizontal orientierten, parallel beabstandeten Stäben (22); wobei
die wenigstens eine vertikale Solarpanelvorrichtung (10) innerhalb eines Abstands der horizontal orientierten Stäbe (22), zwischen mehreren der vertikal orientierten Stäbe (21) alternierend hindurch gefädelt angeordnet ist.

11. Vertikales Solarpanelsystem nach Anspruch 10, wobei ein Muster der alternierend hindurch gefädelten Anordnung der wenigstens einen vertikalen Solarpanelvorrichtung (10) eine ungleichmäßige Aufteilung in Bezug auf zwei gegenüberliegende Seiten des Zaunelementes (20) aufweist; und wobei die ungleichmäßige Aufteilung vorzugsweise eine überwiegende Erstreckung der vertikalen Solarpanelvorrichtung (10) in Bezug auf die Längsrichtung (L) umfasst, an der die primäre photovoltaische Oberfläche der Solarzellen (11) zu den vertikal orientierten Stäben (21) des Zaunelementes (20) abgewandt ist.

## Claims

1. A vertical solar panel device (10) for vertically oriented photovoltaic power generation, comprising:
a plurality of flexible solar cells (11) which are arranged spaced apart from one another in a row and are electrically connected to one another;
a flexible first carrier layer (13) made of a transparent polymer-based material, wherein the solar cells (11) are fixed, at a primary photovoltaic surface, on the first carrier layer (13) by means of a transparent adhesive (12); wherein
the flexible solar cells (11) are configured as bifacial, with a secondary photovoltaic surface which is opposite the primary photovoltaic surface;
a flexible second carrier layer (15) made of a transparent polymer-based material, wherein the flexible solar cells (11) are fixed, at the secondary photovoltaic surface, on the second carrier layer (15) by means of the transparent adhesive (12);
a first flexible protective layer (14) made of a transparent polymer-based material, which is arranged towards an outward-facing side of the first carrier layer (13), and a second flexible protective layer (16) made of a transparent polymer-based material, which is arranged towards an outward-facing side of the second carrier layer (15); wherein the first protective layer (14) and the second protective layer (16) are laminated onto the first carrier layer (13) and the second carrier layer (15), respectively,
**characterized in that**
at at least one end portion of the solar panel device (10), a cross-section of a layer structure comprising the solar cells (11), the first carrier layer (13) and the second carrier layer (15) is covered, towards an outer side of the solar panel device (10), by the first protective layer (14) and/or by the second protective layer (16).

2. The vertical solar panel device (10) according to claim 1, wherein the solar cells (11) have substantially equal dimensions, and wherein, in a horizontally oriented longitudinal direction (L), in which the solar cells (11) are arranged spaced apart from one another in a row, an arrangement interval (A), within which an arrangement of adjacent solar cells (11) repeats, is 40 mm to 60 mm, preferably 50 mm.

3. The vertical solar panel device (10) according to claim 1 or 2, having a dimension in a vertically oriented transverse direction (Q), which extends transversely to the longitudinal direction (L), of 180 mm to 200 mm, preferably 190 mm.

4. The vertical solar panel device (10) according to any one of the preceding claims, having end portions (18A, 18B) terminating in a staggered manner in the horizontally oriented longitudinal direction (L), wherein the end portions (18A, 18B) terminating in a staggered manner are divided into at least two sections with respect to the vertically oriented transverse direction (Q), and the at least two sections each extend outward in the longitudinal direction (L) by a different length.

5. The vertical solar panel device (10) according to any one of the preceding claims, wherein the transparent polymer-based material of the first carrier layer (13) and/or of the second carrier layer (15) comprises ethylene vinyl acetate (EVA).

6. The vertical solar panel device (10) according to any one of the preceding claims, wherein the transparent polymer-based material of the first protective layer (14) and/or of the second protective layer (16) comprises polyethylene terephthalate (PET), ethylene tetrafluoroethylene (ETFE) or, preferably, polyvinyl fluoride (PVF).

7. The vertical solar panel device (10) according to any one of the preceding claims, wherein the first protective layer (14) and/or the second protective layer (16) comprises an outward-facing surface in which a pattern of concave, gradually contoured cavities having a diameter of 1000 to 5000 micrometers, preferably 3000 to 3500 micrometers, and a depth of 100 to 500 micrometers, preferably 250 to 350 micrometers, is formed.

8. The vertical solar panel device (10) according to any one of the preceding claims, having at least one electrical connector (17), which provides an electrical connection between an electrical interconnection of the solar cells (11) and electrical terminals for electrically interconnecting the solar panel device (10) with further solar panel devices (10); wherein the electrical connector (17) comprises a switchable electrical bypass, which is switchable by means of a switching element and provides, between the electrical terminals, a separate bridging connection that is separate from the electrical interconnection of the solar cells (11).

9. The vertical solar panel device (10) according to any one of the preceding claims, wherein, along the row which, in an installation situation in a fence system with vertically extending fence bars, extends transversely to the fence bars, the solar cells (11) have a width of 45 mm to 55 mm.

10. A vertical solar panel system for vertically oriented photovoltaic power generation, comprising:
at least one vertical solar panel device (10) according to any one of claims 1 to 9;
a fence element (20) with vertically oriented, spaced-apart parallel bars (21) and horizontally oriented, spaced-apart parallel bars (22); wherein
the at least one vertical solar panel device (10) is arranged, within a spacing between the horizontally oriented bars (22), in an alternately threaded arrangement between a plurality of the vertically oriented bars (21).

11. The vertical solar panel system according to claim 10, wherein a pattern of the alternately threaded arrangement of the at least one vertical solar panel device (10) has a non-uniform distribution with respect to two opposite sides of the fence element (20); and wherein the non-uniform distribution preferably comprises a predominant extent of the vertical solar panel device (10) with respect to the longitudinal direction (L) on which the primary photovoltaic surface of the solar cells (11) faces away from the vertically oriented bars (21) of the fence element (20).

## Revendications

1. Dispositif de panneau solaire vertical (10) pour la production d'électricité photovoltaïque en orientation verticale, comprenant :
une pluralité de cellules solaires flexibles (11), qui sont agencées à distance les unes des autres en une rangée et reliées électriquement entre elles ;
une première couche support flexible (13) en un matériau transparent à base de polymère, les cellules solaires (11) étant fixées, au niveau d'une surface photovoltaïque primaire, sur la première couche support (13) au moyen d'un adhésif transparent (12) ;
les cellules solaires flexibles (11) étant de configuration bifaciale, avec une surface photovoltaïque secondaire qui est opposée à la surface photovoltaïque primaire ;
une deuxième couche support flexible (15) en un matériau transparent à base de polymère, les cellules solaires flexibles (11) étant fixées, au niveau de la surface photovoltaïque secondaire, sur la deuxième couche support (15) au moyen de l'adhésif transparent (12) ;
une première couche de protection flexible (14) en un matériau transparent à base de polymère, qui est agencée du côté orienté vers l'extérieur de la première couche support (13), et une deuxième couche de protection flexible (16) en un matériau transparent à base de polymère, qui est agencée du côté orienté vers l'extérieur de la deuxième couche support (15), la première couche de protection (14) et la deuxième couche de protection (16) étant laminées respectivement sur la première couche support (13) et la deuxième couche support (15),
**caractérisé en ce que**,
au niveau d'au moins une portion d'extrémité du dispositif de panneau solaire vertical (10), une tranche d'un empilement de couches, comprenant les cellules solaires (11), la première couche support (13) et la deuxième couche support (15), est recouverte, vers un côté extérieur du dispositif de panneau solaire vertical (10), par la première couche de protection (14) et/ou par la deuxième couche de protection (16).

2. Dispositif de panneau solaire vertical (10) selon la revendication 1, dans lequel les cellules solaires (11) présentent des dimensions sensiblement identiques, et dans lequel, dans une direction longitudinale (L) orientée horizontalement, dans laquelle les cellules solaires (11) sont agencées à distance les unes des autres en une rangée, un pas d'agencement (A), selon lequel un agencement de cellules solaires (11) adjacentes se répète, est de 40 mm à 60 mm, de préférence de 50 mm.

3. Dispositif de panneau solaire vertical (10) selon la revendication 1 ou 2, présentant une dimension dans une direction transversale (Q) orientée verticalement, qui s'étend transversalement à la direction longitudinale (L), de 180 mm à 200 mm, de préférence de 190 mm.

4. Dispositif de panneau solaire vertical (10) selon l'une quelconque des revendications précédentes, avec des portions d'extrémité décalées (18A, 18B) dans la direction longitudinale (L) orientée horizontalement, dans lequel les portions d'extrémité décalées (18A, 18B) sont subdivisées, par rapport à la direction transversale (Q) orientée verticalement, en au moins deux sections, et les au moins deux sections s'étendent chacune vers l'extérieur avec une longueur différente dans la direction longitudinale (L).

5. Dispositif de panneau solaire vertical (10) selon l'une quelconque des revendications précédentes, dans lequel le matériau transparent à base de polymère de la première couche support (13) et/ou de la deuxième couche support (15) comprend de l'éthylèneacétate de vinyle (EVA).

6. Dispositif de panneau solaire vertical (10) selon l'une quelconque des revendications précédentes, dans lequel le matériau transparent à base de polymère de la première couche de protection (14) et/ou de la deuxième couche de protection (16) comprend du polyéthylène téréphtalate (PET), de l'éthylène-tétrafluoroéthylène (ETFE) ou, de préférence, du polyfluorure de vinyle (PVF).

7. Dispositif de panneau solaire vertical (10) selon l'une quelconque des revendications précédentes, dans lequel la première couche de protection (14) et/ou la deuxième couche de protection (16) comprend une surface orientée vers l'extérieur, dans laquelle est formé un motif des cavités concaves présentant un profil progressivement incurvé, les cavités présentant un diamètre de 1000 à 5000 micromètres, de préférence de 3000 à 3500 micromètres, et une profondeur de 100 à 500 micromètres, de préférence de 250 à 350 micromètres.

8. Dispositif de panneau solaire vertical (10) selon l'une quelconque des revendications précédentes, présentant au moins un dispositif de connexion électrique (17), qui fournit une connexion électrique entre une interconnexion électrique des cellules solaires (11) et des bornes électriques pour un raccordement électrique du dispositif de panneau solaire vertical (10) avec d'autres dispositifs de panneau solaire vertical (10) ; dans lequel
le dispositif de connexion électrique (17) comprend une dérivation électrique commutable au moyen d'un élément de commutation, qui fournit un pontage, séparé de l'interconnexion électrique des cellules solaires (11), entre les bornes électriques.

9. Dispositif de panneau solaire vertical (10) selon l'une quelconque des revendications précédentes, dans lequel les cellules solaires (11) présentent, le long de la rangée qui, en situation de montage dans un système de clôture avec des barreaux de clôture s'étendant verticalement, s'étend transversalement aux barreaux de clôture, une largeur de 45 mm à 55 mm.

10. Système de panneaux solaires verticaux pour la production d'électricité photovoltaïque en orientation verticale, comprenant :
au moins un dispositif de panneau solaire vertical (10) selon l'une quelconque des revendications 1 à 9 ;
un élément de clôture (20) avec des barreaux (21) orientés verticalement, espacés parallèlement, et des barreaux (22) orientés horizontalement, espacés parallèlement ; dans lequel
ledit au moins un dispositif de panneau solaire vertical (10) est disposé, à l'intérieur d'un espacement entre les barreaux (22) orientés horizontalement, entre plusieurs des barreaux (21) orientés verticalement, selon un agencement par enfilage alterné.

11. Système de panneaux solaires verticaux selon la revendication 10, dans lequel un motif de l'agencement par enfilage alterné dudit au moins un dispositif de panneau solaire vertical (10) présente une répartition non uniforme par rapport à deux côtés opposés de l'élément de clôture (20) ; et dans lequel la répartition non uniforme comprend de préférence une extension prédominante dudit au moins un dispositif de panneau solaire vertical (10) par rapport à la direction longitudinale (L), au niveau de laquelle la surface photovoltaïque primaire des cellules solaires (11) est orientée à l'opposé des barreaux (21) orientés verticalement de l'élément de clôture (20).
